(19)

Europäisches Patentamt

European Patent Office

Office européen des brevets

(11) **EP 4 311 711 A1**

(12) **EUROPEAN PATENT APPLICATION**

(43) Date of publication:
**31.01.2024  Bulletin 2024/05**

(21) Application number: **23187089.0**

(22) Date of filing: **21.07.2023**

(51) International Patent Classification (IPC):
**B60L 3/00** (2019.01)   **B60L 53/16** (2019.01)
**B60L 53/18** (2019.01)   **B60L 53/30** (2019.01)
**B60L 53/66** (2019.01)   B60L 3/12 (2006.01)

(52) Cooperative Patent Classification (CPC):
**B60L 53/16; B60L 3/0046; B60L 53/18;**
**B60L 53/305; B60L 53/665;** B60L 3/12;
B60L 53/60; B60L 53/62; B60L 55/00

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **25.07.2022  US 202217872496**

(71) Applicant: **ABB E-mobility B.V.**
**2629 JG Delft (NL)**

(72) Inventors:
- **Y A, Ravishankar**
  **560066 Bangalore (IN)**
- **THANGAVELU, Sukumara**
  **560068 Bangalore (IN)**
- **GARCIA-FERRE, Francisco**
  **5400 Baden (CH)**

(74) Representative: **Zimmermann & Partner**
**Patentanwälte mbB**
**Postfach 330 920**
**80069 München (DE)**

(54) **ELECTRIC VEHICLE (EV) CROSS CONNECTORS FOR EV CHARGING**

(57)      In one aspect, a cross-connect cable for charging an electric vehicle (EV) is provided. The cross-connect cable comprises wiring, first and second charging plugs, a sensor, and a controller. The wiring comprises power conductors and communication lines. The first and second charging plugs are electrically coupled to opposite ends of the wiring. The sensor is configured to measure a voltage of, and a current carried by, the power conductors. The controller is configured to determine whether the first and second charging plugs have been electrically connected to first charging port of a power source and a second charging port of the EV, respectively. The controller is further configured to initiate a charging session from the power source to the EV, and calculate, based the voltage and the current, energy delivered from the power source to the EV for the charging session.

FIG. 1

**Description**

BACKGROUND

The field of the disclosure relates to electric vehicles, and more particularly, to cross connectors for charging electric vehicles.

An Electric vehicle (EV) is driven by electric motors, which are powered by a rechargeable battery within the EV. As the rechargeable battery has a finite energy storage, the rechargeable battery is typically recharged when the remaining charge falls below a desired charge point. An EV may be recharged in a number of different ways, including recharging the EC at public EV chargers, at-home chargers, etc. Public EV chargers provide the ability to recharge the EV when away from an at-home charger, but different public chargers may utilize different types of charging connectors and/or different mechanisms for authenticating the user, monitoring the energy delivered during charging, and accounting for the cost of the energy transaction. The result is that a typical EV user may be tasked with subscribing to a number of different EV charging services, and/or the EV user may have to bypass some EV chargers that do not support the type of charging connector utilized by the EV.

Further, during EV charging, the user may be tasked with logging into a website or an application for a vendor of the EV charger, and/or may be tasked with swiping a credit card, either of which may be unavailable to the user. Further, during EV charging, it may be difficult to verify the amount of energy provided to the rechargeable battery of the EV, as each EV charging vendor may utilize its own method for calculating the energy delivered. In some cases, the battery management system of the EV may show the energy delivered to and/or stored by the rechargeable battery, but this information may not be accurate.

As charging times may vary from a few minutes to a few hours, it may not be practical for the EV user to remain at the EV charger during the charging process. In addition, different public EV chargers may utilize different methods and/or may not utilize any methods at all, for informing the user of the status of the current charging operation.

Based on the forgoing discussion, it therefore remains desirable to improve upon the operation and performance of the EV charging process for EVs.

BRIEF DESCRIPTION

In one aspect, a cross-connect cable for charging an EV is provided. The cross-connect cable comprises wiring, a first charging plug, a second charging plug, at least one sensor, and a controller. The wiring comprises one or more power conductors and one or more communication lines. The first charging plug and the second charging plug are electrically coupled to the wiring at opposite ends of the wiring. The at least one sensor is configured to measure a voltage of the one or more power conductors and measure a current carried by the one or more power conductors. The controller is communicatively coupled with the wiring and the at least on sensor. The controller is configured to determine whether the first charging plug and the second charging plug have been electrically connected to a first charging port of a power source and a second charging port of the EV, respectively. The controller is further configured to initiate a charging session from the power source to the EV in response to determining that the first charging plug and the second charging plug have been electrically connected, and calculate, based the voltage and the current, energy delivered from the power source to the EV for the charging session.

In another aspect, a method of operating a cross-connect cable to charge an EV is provided. The method comprises determining, by a controller of the cross-connect cable, whether a first charging plug and a second charging plug of the cross-connect cable have been electrically connected to a first charging port of a power source and a second charging port of the EV, respectively. The first charging plug and the second charging plug are disposed at, and are electrically coupled to, opposite ends of the wiring of the cross-connect cable. The wiring comprises one or more power conductors and one or more communication lines. The method further comprises initiating a charging session from the power source to the EV in response to determining that the first charging plug and the second charging plug have been electrically connected. The method further comprises measuring, by at least one sensor of the cross-connect cable, a voltage of the one or more power conductors, and measuring, by the at least one sensor, a current carried by the one or more power conductors. The method further comprises calculating, by the controller, energy delivered from the power source to the EV for the charging session based the voltage and the current.

In another aspect, a cross-connect cable for charging an EV is provided. The cross-connect cable comprises wiring, a first charging plug, a second charging plug, at least one wireless interface, and a controller. The wiring comprises one or more power conductors and one or more communication lines. The first charging plug and the second charging plug are electrically coupled to the wiring at opposite ends of the wiring. The controller is configured to receive, utilizing the at least one wireless interface, at least one of a key, a certificate, and a password to authenticate a charging session. The controller is further configured to determine whether the first charging plug has been electrically connected to a first charging port of an EV charger and the second charging plug has been electrically connected to a second charging port of the EV. The controller is further configured to transmit, utilizing the at least one wireless interface, the at least one of the key, the certificate, and the password to the EV charger in response to determining that the first charging plug and the second charging plug have been electrically connected, and initiate the charging session from the EV charger to the EV in response to the at least one of the key, the certificate, and the password authenticating the charging session.

## DRAWINGS

These and other features, aspects, and advantages of the present disclosure will become better understood when the following detailed description is read with reference to the accompanying drawings in which like characters represent like parts throughout the drawings, wherein:

FIG. 1 depicts a cross-connect cable for charging an electric vehicle in an exemplary embodiment.

FIGS. 2-6 depict different configuration of the cross-connect cable of FIG. 1 in exemplary embodiments.

FIG. 7 depicts a cross-connect cable in another exemplary embodiment.

FIG. 8 depicts a graph of a time-synced energy measurement during a charging session in an exemplary embodiment.

FIG. 9 depicts an EV that includes a cross-connect cable in an exemplary embodiment.

FIG. 10 is a block diagram of another controller for the cross-connect cable of FIG. 1 in an exemplary embodiment.

FIG. 11 is a flow chart of a method of operating a cross-connect cable to charge an EV in an exemplary embodiment.

FIGS. 12 and 13 depict additional details of the method of FIG. 11 in exemplary embodiments.

Unless otherwise indicated, the drawings provided herein are meant to illustrate features of embodiments of this disclosure. These features are believed to be applicable in a wide variety of systems comprising one or more embodiments of this disclosure. As such, the drawings are not meant to include all conventional features known by those of ordinary skill in the art to be required for the practice of the embodiments disclosed herein.

## DETAILED DESCRIPTION

In the following specification and the claims, reference will be made to a number of terms, which shall be defined to have the following meanings.
The singular forms "a", "an", and "the" include plural references unless the context clearly dictates otherwise.
"Optional" or "optionally" means that the subsequently described event or circumstance may or may not occur, and that the description includes instances where the event occurs and instances where it does not.
Approximating language, as used herein throughout the specification and claims, may be applied to modify any quantitative representation that could permissibly vary without resulting in a change in the basic function to which it is related. Accordingly, a value modified by a term or terms, such as "about", "approximately", and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise.
As used herein, the terms "processor" and "computer," and related terms, e.g., "processing device," "computing device," and "controller" are not limited to just those integrated circuits referred to in the art as a computer, but broadly refers to a microcontroller, a microcomputer, an analog computer, a programmable logic controller (PLC), an application specific integrated circuit (ASIC), and other programmable circuits, and these terms are used interchangeably herein. In the embodiments described herein, "memory" may include, but is not limited to, a computer-readable medium, such as a random-access memory (RAM), a computer-readable non-volatile medium, such as a flash memory. Alternatively, a floppy disk, a compact disc - read only memory (CD-ROM), a magneto-optical disk (MOD), and/or a digital versatile disc (DVD) may also be used. Also, in the embodiments described herein, additional input channels may be, but are not limited to, computer peripherals associated with an operator interface such as a touchscreen, a mouse, and a keyboard. Alternatively, other computer peripherals may also be used that may include, for example, but not be limited to, a scanner. Furthermore, in the example embodiment, additional output channels may include, but not be limited to, an operator interface monitor or heads-up display. Some embodiments involve the use of one or more electronic or computing devices. Such devices typically include a processor, processing device, or controller, such as a general-purpose central processing unit (CPU), a graphics processing unit (GPU), a microcontroller, a reduced instruction set computer (RISC) processor, an ASIC, a programmable logic controller (PLC), a field programmable gate array (FPGA), a digital signal processing (DSP) device, and/or any other circuit or processing device capable of executing the functions described herein. The methods described herein may be encoded as executable instructions embodied in a computer readable medium, including, without limitation, a storage device and/or a memory device. Such instructions, when executed by a processing device, cause the processing device to perform at least a portion of the methods described herein. The above examples are not intended to limit in any way the definition and/or meaning of the term processor and processing device.

As discussed previously, current public EV charger implementations provide a number of challenges to the EV user, including the use of vendor-specific payment systems, applications, subscriptions, different EV charger connector types, energy monitoring, and notification mechanisms.

In the embodiments described herein, cross-connect cables for EVs are described that include built-in EV charging authorization, charge monitoring, and flashover disconnect during arc events. The cross-connect cables implement a variety of different EV charger connector types, which provides more flexibility to the user regarding where to charge an EV. The cross-connect cables include current and voltage monitoring and can disconnect the charging session when the voltage, current, and/or power exceed a threshold. Further, the current and voltage monitoring is used to dynamically measure the power supplied to the EV batteries during charging. In various embodiments, the cross-connect cables provide arc flash and IR detection, for detecting flashover events. A controller within the cross-connect cables may include one or more processors, memory, Bluetooth, Wi-Fi, cellular, ANT, ANT+, near field communication (NFC), radio frequency identification (RFID), or other wireless interfaces. The measured energy, current, and/or voltage during charging may be stored in local memory, and the charging data may be shared via Bluetooth or other wireless interfaces to mobile devices (e.g., to a user's cell phone or tablet), or via cellular networks using a modem to cloud storage. The RFID generator may be used to provide EV charging authorization. Further, the controller may utilize NFC interfaces for transmitting authorization signals to the EV charger to authenticate an EV charging session. The controller may include an internal clock, which may be used to record charging power over time (for dynamic energy pricing) with local storage in a file. The controller may also transmit charging information to a mobile device of the user for remote monitoring of the charging session.

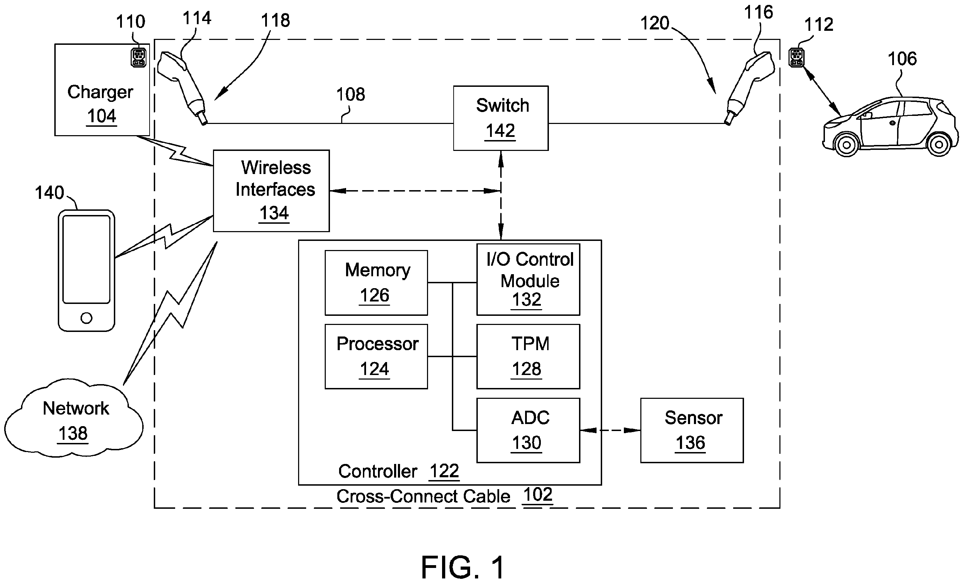

FIG. 1 depicts a cross-connect cable 102 for charging an electric vehicle in an exemplary embodiment. Generally, cross-connect cable 102 provides a charging interface between a charger 104 (e.g., a public charging point or an at-home charging point) and an electric vehicle (e.g., EV 106). In this embodiment cross-connect cable 102 comprises wiring 108 that carries electrical power and control signals between a charging port 110 of charger 104 via a charging plug 114 and a charging port 112 of EV 106 via a charging plug 116. Wiring 108 of cross-connect cable 102 is electrically coupled with charging plugs 114, 116 disposed on opposite ends 118, 120 of cross-connect cable 102 that mate with charging ports 110, 112, respectively. Charging ports 110, 112 and charging plugs 114, 116 may be the same type or different types of commercially available charging interfaces. Some examples of the different types of charging interfaces include J1772, Mennekes, combined charging system 1 (CCS1), CCS2, CHAdeMO, GB/T, etc. In some embodiments, cross-connect cable 102 operates to convert between different charging interfaces, including converting signaling protocols from one type of charging interface to another type of charging interface in addition to providing a current path between charging plugs 114, 116 through wiring 108.

Cross-connect cable 102 in this embodiment further comprises a controller 122, which controls the operation of cross-connect cable 102. Controller 122 in this embodiment comprises a processor 124, a memory 126, a trusted platform module (TPM) 128, one or more analog-to-digital converters (ADC) 130, and an input/output (I/O) control module 132. Any of the elements of controller 122 may be separate components or integrated together in different embodiments. For example, in some embodiments, processor 124 and memory 126 are integrated together within TPM 128. Cross-connect cable 102 in this embodiment further comprises one or more wireless interfaces 134 and one or more sensors 136.

In some embodiments, controller 122 can generate a dynamic RFID identification or a dynamic NFC signal during an authorization process with charger 104. Charger 104 receives a key, a certificate, and/or a password via an RFID signal or a NFC signal from cross-connect cable 102. Charger 104 sends the key, the certificate and/or the password to the cloud via a network 138. The cloud checks the key, the certificate, and/or the password with its authorization registry database. Once cross-connect cable 102 provides identification using the key, the certificate, and/or the password, cross-connect cable 102 sends a command to charger 104 to start charging and, and cross-connect cable 102 begins recording the charging information for the charging session.

Processor 124 comprises any component, system, or device that controls the operation of controller 122. Processor 124 may, for example, execute instructions stored in memory 126 when performing the functions described herein for controller 122. Memory 126 comprises any component, system, or device that stores data. Memory 126 may comprise RAM, EEPROM, FLASH, or combinations thereof.

TPM 128 comprises any component, system, or device which stores secure data. Some examples of secure data include encryption keys and/or certificates and/or passwords, which may be used when controller 122 communicates with external systems. Once controller 122 connects to the cloud (e.g., via network 138), controller 122 may receive the key, the certificate, and/or the password. The certificate and password may include a key to authenticate cross-connect cable 102 with charger. The certificate and key are stored in TPM 128.

Wireless interfaces 134 comprise any component, system, or device which provides wireless connectivity between controller 122 and other devices or systems. For instance, wireless interfaces 134 may communicate directly with user equipment (UE) 140 of a user and/or may communicate with other devices or systems, including UE 140, via network 138. Some examples of UE 140 include smart phones, tablets, smart watches, etc. Some examples of the supported wireless standards for wireless interfaces 134 include Wi-Fi, ANT, ANT+, cellular (e.g., 3G, 4G, 5G cellular networks), Bluetooth, NFC, RFID, etc. Network 138 may comprise, in some embodiments, the Internet. Wireless interfaces 134 may be proximate to charging plug 114 and/or charging plug 116 in different embodiments, due to the limited range of some types of wireless communications supported by wireless interfaces 134.

Sensors 136 comprise any component, system, or device, that provides information to controller 122 (e.g., via ADC 130) regarding the operation of cross-connect cable 102. Sensors 136, for instance, may measure voltages (e.g., the voltage at charging plugs 114, 116), current (e.g., the current flowing between charging plugs 114, 116 through wiring 108), temperatures, (e.g., the temperature at charging plugs 114, 116 and/or controller 122 and/or wiring 108). In some embodiments, sensors 136 comprise flashover (arc) sensors and/or infra-red (IR) sensors, which detect electrical discharges at charging plug 114 and/or charging plug 116. Arc sensors convert light lux into a voltage, which may be read by processor 124 to identify an arc flash event and terminate charging (e.g., the voltage generated by the arc sensor exceeds a threshold voltage). IR sensors convert IR signals to a voltage, which may be read by processor 124 to also identify an arc flash event and terminate charging (e.g., the voltage generated by the IR sensor exceeds a threshold voltage). In some embodiments, if the current in cross-connect cable 102 flows in the opposite direction than normal (e.g., current flows from charging port 112 of EV 106 to charging port 110 of charger 104), processor 124 may terminate charging. However, cross-connect cable 102 provides bi-directional charging between EVs in some embodiments. Sensors 136 may be proximate to charging plug 114 and/or charging plug 116 in different embodiments, due to the limited range of some types of flashover sensors.

I/O control module 132 comprises any component, system, or device which interfaces with devices of cross-connect cable 102. For instance, I/O control module 132 may control the operation of a switch 142 which selectively passes current between charging plugs 114, 116 over wiring 108. Switch 142 may comprise solid-state devices, mechanical devices, or combinations thereof. During operation, processor 124 may open/close switch 142 as desired to stop/start charging operations. Processor 124 may open switch 142 when arc events are detected during charging or if the charging current is flowing in the opposite direction (e.g., current flows from charging port 112 of EV 106 to charging port 110 of charger 104). Processor 124 may also open switch 142 if the voltage, current, and/or power at cross-connect cable 102 exceeds a threshold.

Typically, during EV charging there is a need for authorizing a person to do an energy transaction. Often, the user swipes a credit card, RFID card, or may use an application on their mobile device to begin the energy transfer. Cross-connect cable 102 comprises built-in RFID and/or NFC interfaces (via wireless interfaces 134) which transmit authorization information to charger 104 to authenticate charging for EV 106. Sensors 136 monitor the voltages and currents at cross-connect cable 102, which are used to calculate power. Power over charging time is energy, which may be recorded and timestamped using an internal clock (not shown) to record the power over time (for dynamic energy pricing), which may be stored in a local file (e.g., stored in memory 126). Wireless interfaces 134 may be used to transmit charging information to UE 140 and/or other devices or systems via network 138 for remote monitoring. In some embodiments, the charging data is sent via wireless interfaces 134 for EV energy transaction verification and to keep a log of each energy transaction.

When controller 122 connects to the cloud (e.g., via network 138), the internal time of controller 122 is synchronized (e.g., via the network time protocol (NTP)) to a time server (not shown). Controller 122 may also synchronize its internal clock via Bluetooth when communicating with a mobile charging application executing on LTE 140. Generally, time synced data is continuously incremented in real time. If a time sync is not available, then the internal clock (not shown) of controller 122 is used for time stamping energy transaction data. Cross-connect cable 102 may be self-powered in some embodiments, obtaining power from charger 104 and/or EV 106 when charging plugs 114, 116 are plugged into charging ports 110, 112, respectively. Once cross-connect cable 102 is powered, processor 124 may request a time sync from LTE 140 (via a charging application executing on UE 140) or from a time server via network 138 utilizing NTP or some other time synchronization protocol.

In some embodiments, processor 124 performs protocol translations between different charging interfaces. For example, if charging port 110 at charger 104 utilizes CCS2 and charging port 112 at EV 106 utilizes CHAdeMO, then processor 124 may convert CCS2 protocols and control signals at charging plug 114 to CHAdeMO protocols and controls signals for presentation at charging plug 116. Processor 124 may also convert CHAdeMO protocols at charging plug 116 to CCS2 protocols and control signals for presentation at charging plug 114. This allows EV 106 to be charged at a larger number of charging stations utilizing cross-connect cable 102. For example, a user of EV 106 may have a number of different types of cross-connect cable 102, which are used by the user of EV 106 depending on the type of charging port 110 on charger 104 and charging port 112 on EV 106.

During a charging operation, if the voltage, current, and/or power sensed and/or calculated by processor 124 is greater than a threshold amount (e.g., for a predefined amount of time), then switch 142 is opened by processor 124 (e.g., via I/O control module 132) to electrically disconnect the power conductors of charging ports 110, 112 from each other and to terminate the charging operation. This termination of charging is independent of charger 104, thereby providing additional safety to the user and/or EV 106.

In some embodiments, I/O control module 132 is coupled with a button (not shown) that allows the user to manually start/stop charging and/or turn on/off controller 122.

In some embodiments, the operator and/or owner of charger 104 utilizes dynamic energy pricing based one demand and supply. During dynamic power measurements performed when charging EV 106, the dynamic energy cost is recorded during an energy transaction. This allows the user of EV 106 to verify the energy transaction information provided by charger 104.

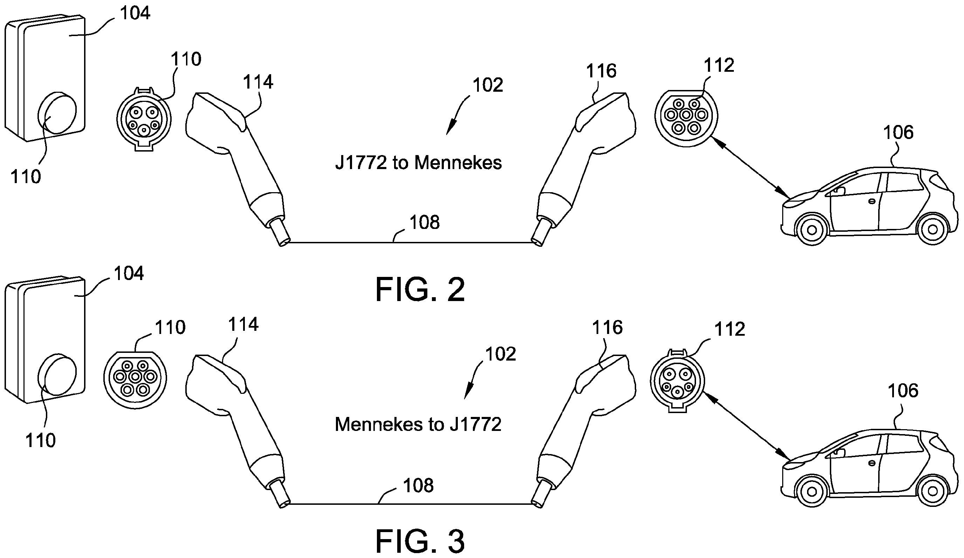

FIGS. 2-6 depict different configurations of cross-connect cable 102 in exemplary embodiments. Controller 122 and switch 142 are not shown in FIGS. 2-6. In particular, FIG. 2 depicts an embodiment of cross-connect cable 102 where charging plug 114 for charger 104 comprises a J1772 type connector and charging plug 116 for EV 106 comprises a Mennekes type connector. In this embodiment, processor 124 (see FIG. 1) converts between J1772 protocols and control signals and Mennekes protocols and control signals. Wiring 108 electrically couples the appropriate power conductors and control lines found on charging port 110 with charging port 112 via charging plugs 114, 116, respectively.

FIG. 3 depicts an embodiment of cross-connect cable 102 where charging plug 114 coupled to charging port 110 of charger 104 comprises a Mennekes type connector and charging plug 116 coupled to charging port 112 of EV 106 comprises a J1772 type connector. In this embodiment, processor 124 (see FIG. 1) also converts between J1772 protocols and control signals and Mennekes protocols and control signals. Wiring 108 electrically couples the appropriate power conductors and control lines found on charging port 110 with charging port 112 via charging plugs 114, 116, respectively. The difference between FIGS. 2 and 3 is that cross-connect cable 102 has been reversed in FIG. 3 as compared to FIG. 2.

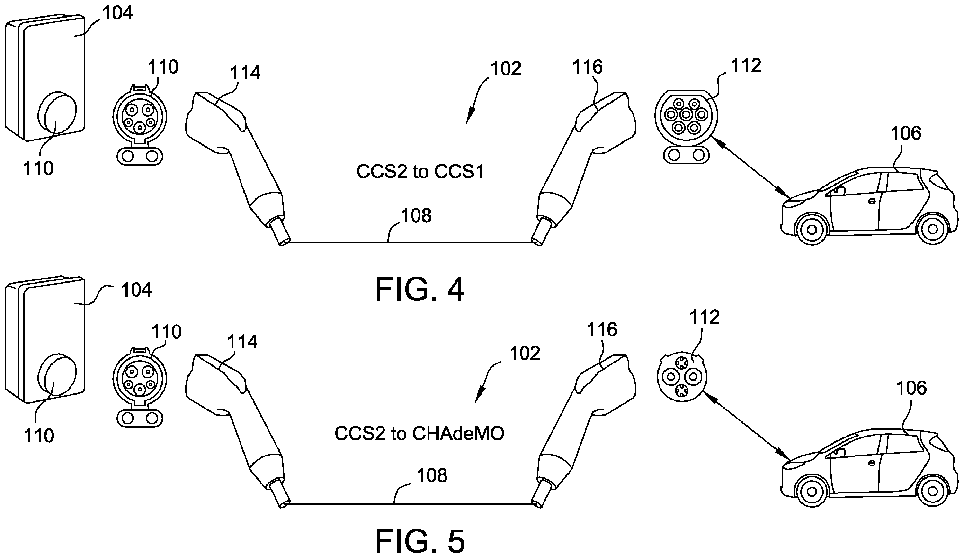

FIG. 4 depicts an embodiment of cross-connect cable 102 where charging plug 114 coupled to charging port 110 of charger 104 comprises a CCS2 type connector and charging plug 116 coupled to charging port 112 ofEV 106 comprises a CCS1 type connector. In this embodiment, processor 124 (see FIG. 1) converts between CCS2 protocols and control signals and CCS1 protocols and control signals. Wiring 108 electrically couples the appropriate power conductors and control lines found on charging port 110 with charging port 112 via charging plugs 114, 116, respectively.

FIG. 5 depicts an embodiment of cross-connect cable 102 where charging plug 114 coupled to charging port 110 of charger 104 comprises a CCS2 type connector and charging plug 116 coupled to charging port 112 of EV 106 comprises a CHAdeMO type connector. In this embodiment, processor 124 (see FIG. 1) converts between CCS2 protocols and control signals and ChAdeMO protocols and control signals. Wiring 108 electrically couples the appropriate power conductors and control lines found on charging port 110 with charging port 112 via charging plugs 114, 116, respectively.

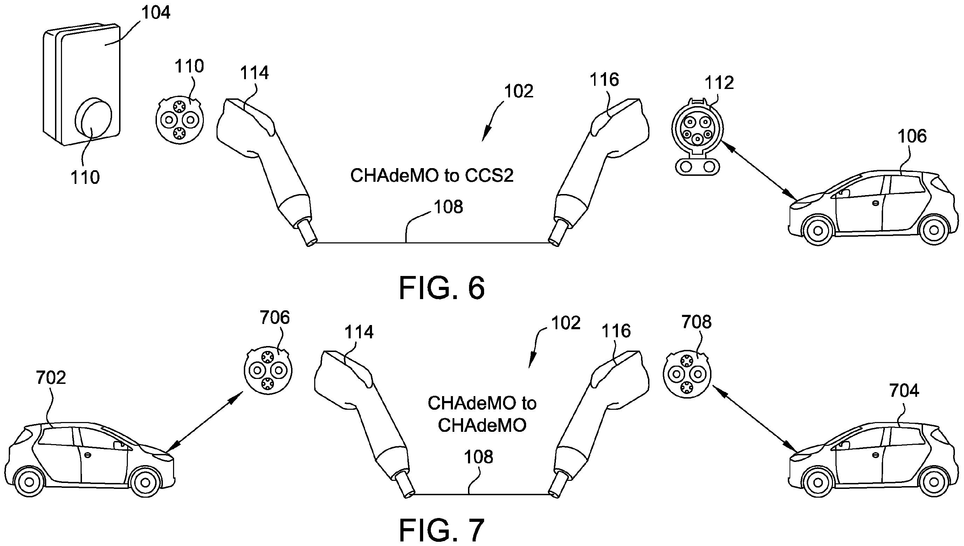

FIG. 6 depicts an embodiment of cross-connect cable 102 where charging plug 114 coupled to charging port 110 of charger 104 comprises a CHAdeMO type connector and charging plug 116 coupled to charging port 112 ofEV 106 comprises a CCS2 type connector. In this embodiment, processor 124 (see FIG 1) converts between CHAdeMO protocols and control signals and CCS2 protocols and control signals. Wiring 108 electrically couples the appropriate power conductors and control lines found on charging port 110 with charging port 112 via charging plugs 114, 116, respectively. The difference between FIGS. 5 and 6 is that cross-connect cable 102 has been reversed in FIG. 6 as compared to FIG. 5.

FIG. 7 depicts cross-connect cable 102 in another exemplary embodiment. In this embodiment, cross-connect cable 102 is used to transfer energy between EV 702 and EV 704 (e.g., cross-connect cable 102 provides bi-directional charging). In particular, charging plug 114 of cross-connect cable 102 couples to charging port 706 of EV 702 and charging plug 116 of cross-connect cable 102 couples to charging port 708 of EV 704. In this embodiment, the connector types are CHAdeMO for both EVs 702, 704. Electrical power in cross-connect cable 102 may flow in either direction depending on whether EV 702 is supplying power to charge the batteries of EV 704 or EV 704 is supplying power to charge the batteries of EV 702. During the charging session, cross-connect cable 102 may operate similarly as to previously described when connected to charger 104. For example, EV to EV charging may utilize the same or similar authentication, arc flash detection, charge control, and/or power measurement and recording features previously described, along with protocol conversion and power conductor / control line mapping between charging plugs 114, 116.

Although FIGS. 2-7 depict specific examples of different types of EV charging interfaces for cross-connect cable 102, cross-connect cable 102 is not limited to these specific examples. Rather, cross-connect cable 102 may utilize a variety of different types of EV charging interfaces at charging plugs 114, 116, and controller 122 and wiring 108 may operate to convert power conductors, protocol signals, and/or control lines between the different types of charging interfaces in other embodiments.

Referring again to FIGS. 1-6, once charger 104 receives authentication (approval) from the charging vendor, charger 104 begins the charging process for EV 106. Charger 104 calculates the charging energy during the charge, with dynamic energy pricing. Concurrently, processor 124 of cross-connect cable 102 also measures the total energy (e.g., via sensors 136) and creates an energy record transaction. The energy record transaction is sent to the cloud (e.g., via wireless interfaces 134 and network 138), and can be used to verify the energy transaction calculated by charger 104. In an embodiment, the energy transaction information from cross-connect cable 102 is sent to a block chain. The energy transaction information may be sent to a dedicated block chain software for energy verification, with a verified block of energy transaction information added to the block chain. The block chain may be stored in a database associated with a plurality of computers or servers associated with an EV system operator and/or a plurality of EV energy distribution vendors.

Table 1, below, is one example of an energy record transaction that may be generated by cross-connect cable 102 and sent to the cloud.

Table 1

| Energy transaction | Value |
|---|---|
| Device account name: | Tesla Car 1 |
| Device owner name: | Shankar |
| EV serial number: | Tesla IN KA53 L 4742 |
| EV public unique ID : | 87af7157 |
| EV parent - EV manufacturer unique ID | 23776d4e |
| EV charging station name | ABB charging station |
| GPS location of Charge point | 12.993716974042588, 77.70606307666043 |
| Transaction number | 0d024285-bc30-4828-8c9e-ef65d0b2fc96 |
| | |
| EV charger info : | ABB CHAdeMO 1.0 |
| EV charging point unique ID | 247e0a80 |
| Parent EV Energy distributor vendor | 95b7e7843b2f |
| Charging type | CHAdeMO 50KWh |
| Time stamp of total energy consumption during charging | 19-Sept-20:10:20AM (Start) 19-Sept-20:10:40AM (End) |
| Total Energy | 100kWh |
| Total cost of consumption by EV: Energy: measurement | 1234 INR |
| Hash of each Transaction | 8DE98019CDD599C75DFB96CB0004922B0AF2074D 277882FF0A7B2BD3DF413F1D |

The hash (e.g., using SHA256) information is also stored for energy verification, and is used to verify the energy transaction stored in the cloud.

As EV charging can take from several minutes to several hours, having communication capabilities built-in to cross-connect cable 102 enables the charging information to be remotely monitored by a user of EV 106. Using Bluetooth, ANT, and/or ANT+, the user could monitor the charging over several meters away via a mobile application executing at LTE 140, without using a cellular connection. This allows the user to remotely start/stop charging and receive any alarms generated by cross-connect cable 102, such as an overvoltage alarm, an over current alarm, an over-power alarm, a flashover event, etc., without using a cellular network.

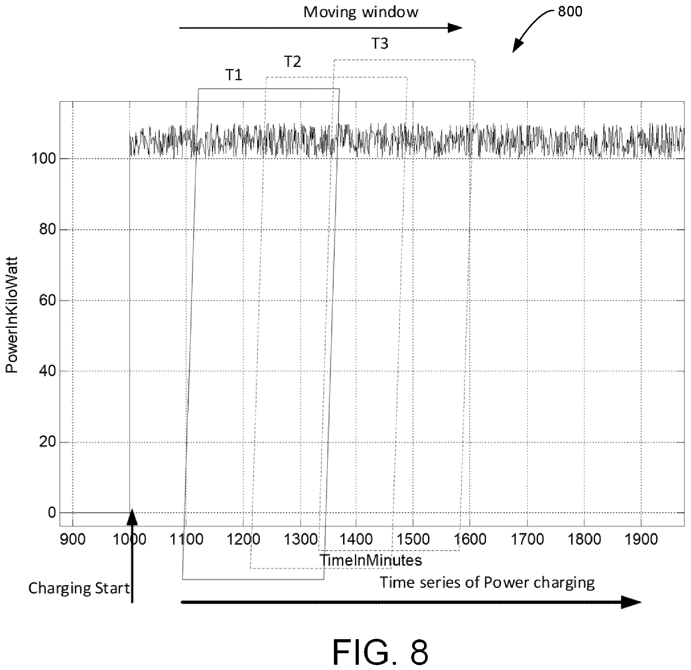

FIG. 8 depicts a graph 800 of a time-synced energy measurement during a charging session in an exemplary embodiment, with table 2 below depicting a time series of energy charging data.

Table 2

|  | Time-1 | Time-2 | ... | Time-n |
|---|---|---|---|---|
| Device ID | CrossConnect 1 | CrossConnect 1 | ... | CrossConnect1 |
| Power | P1 | P2 | ... | Pn |
| Time stamp | t_1 | t-2 | ... | t-n |
| Cumulative Energy | P1*t_1 | P1*t_1 + P2*t_2 |  | $\sum_{t=0}^{T} P_t * \Delta t$ |
| Cumulative Energy cost | P1*t_1*c1 | P1*t_1 *c1+ P2*t_2*c2 |  | $\sum_{t=0}^{T} P_t * \Delta t * C_t$ |

With respect to FIG. 8 and table 2, $V_t$ = voltage measured at time "t", $I_t$ = current measured at time "t", $P_t$ is calculated instantaneous power.

Calculation of: *Total charging* $Energy = \pm \sum_{t=0}^{T} P_t * \Delta t$, $\Delta t =$ time between measurement iteration , and T = total time of the charging period.

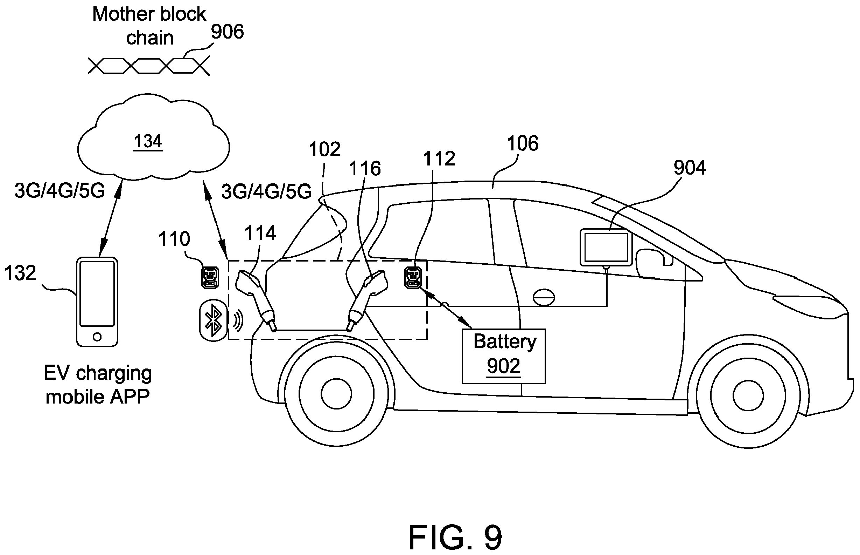

In some embodiments, cross-connect cable 102 may be housed within EV 106, as depicted in FIG. 9. FIG. 9 depicts EV 106 including cross-connect cable 102 in an exemplary embodiment. In some cases, a battery management system (not shown) of EV 106 may not include energy measurement. Cross-connect cable 102 can facilitate charging authorization and energy measurement for charging a battery 902 of EV 106. A display 904 ofEV 106 can communicate with controller 122 (see FIG. 1) using a controller area network (CAN) bus or another wired or wireless interface to provide information to a user of EV 106 regarding the energy transaction. In an embodiment, the energy transaction information from cross-connect cable 102 is sent to a block chain 906. The energy transaction information may be sent to a dedicated block chain software for energy verification, with a verified block of energy transaction information added to block chain 906. Block chain 906 may be stored in a database associated with a plurality of computers or servers associated with an EV system operator and/or a plurality of EV energy distribution vendors.

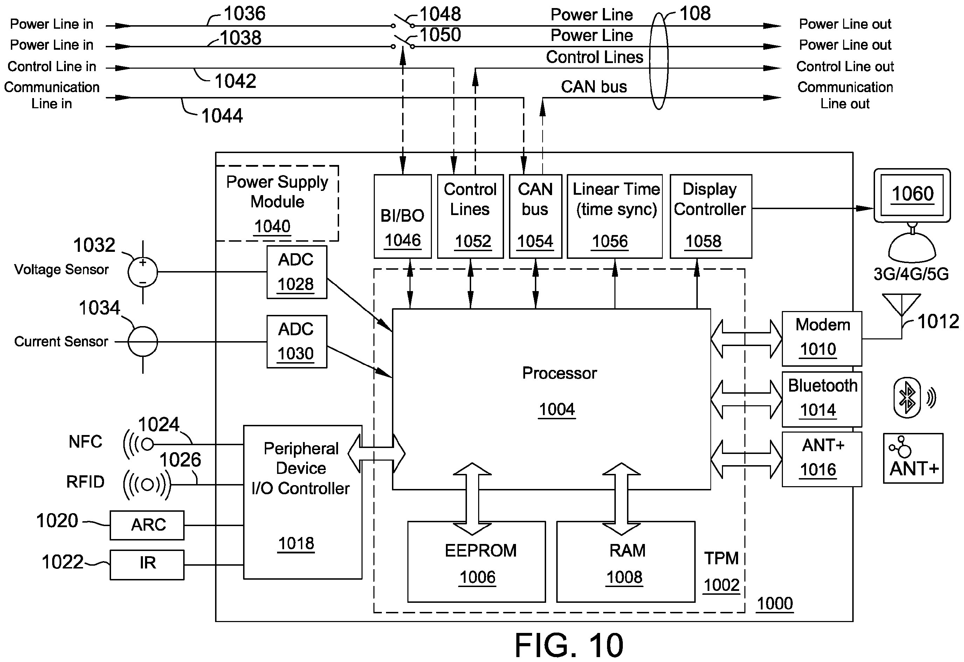

FIG. 10 is a block diagram of another controller 1000 for cross-connect cable 102 in an exemplary embodiment. In this embodiment, controller 1000 comprises a TPM 1002, which comprises a processor 1004, an EEPROM 1006, and a RAM 1008. EEPROM 1006 may securely store encryption keys, certificates, and/or passwords for cross-connect cable 102. Controller 1000 further comprises a modem 1010, which is electrically coupled to an antenna 1012 for communicating to cellular networks. Controller 1000 further comprises a Bluetooth module 1014, for short range communication with Bluetooth enable devices, and an ANT+ module 1016 for communicating to ANT+ enabled devices. Controller 1000 in this embodiment further comprises I/O controller 1018, which communicates with an arc flash sensor 1020 and an IR sensor 1022, and also with a NFC interface 1024 and an RFID interface 1026. Controller 1000 further comprises one or more analog-to-digital converters (ADCs) 1028, 1030 that measure the output of one or more voltage sensors 1032 and one or more current sensor 1034, respectively. Voltage sensors 1032 measures various voltages in cross-connect cable 102, including the voltages at charging plugs 114, 116 (see FIG. 1). Current sensors 1034 measures current in power conductors 1036, 1038.

In some embodiments, controller 1000 further comprises a power supply module 1040, which provides power to controller 1000. Power supply module 1040 receives electrical power from power conductors 1036, 1038 of wiring 108. In other embodiments, wiring 108 may comprise more or fewer power conductors 1036, 1038.

In this embodiment, wiring 108 comprises one or more control lines 1042 and one or more CAN bus communication lines 1044. In this embodiment, controller 1000 further comprises I/O module 1046, which controls switches 1048, 1050 for power conductors 1036, 1038, respectively. A control line module 1052 provides input/output conversion for control lines 1042, and a CAN bus module 1054 provides a CAN bus interface for processor 1004 to implement a protocol conversion for data sent over CAN bus communication lines 1044. A clock module 1056 provides timekeeping functions for controller 1000 and a display controller 1058 of controller 1000 interfaces with a display 1060, which may be used to provide information to a user of EV 106. Controller 1000 may operate similar to that previously described with respect to controller 122 of FIG. 1

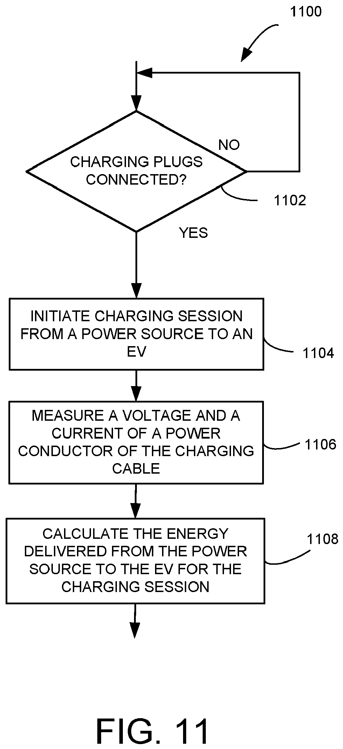

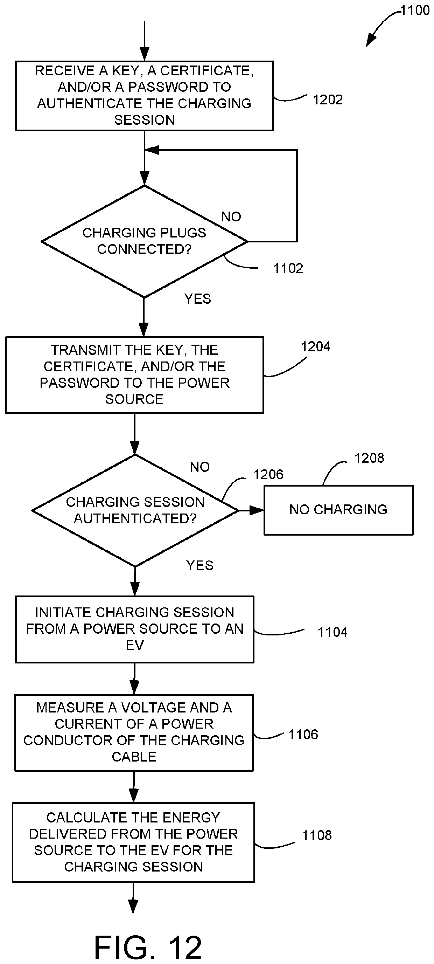

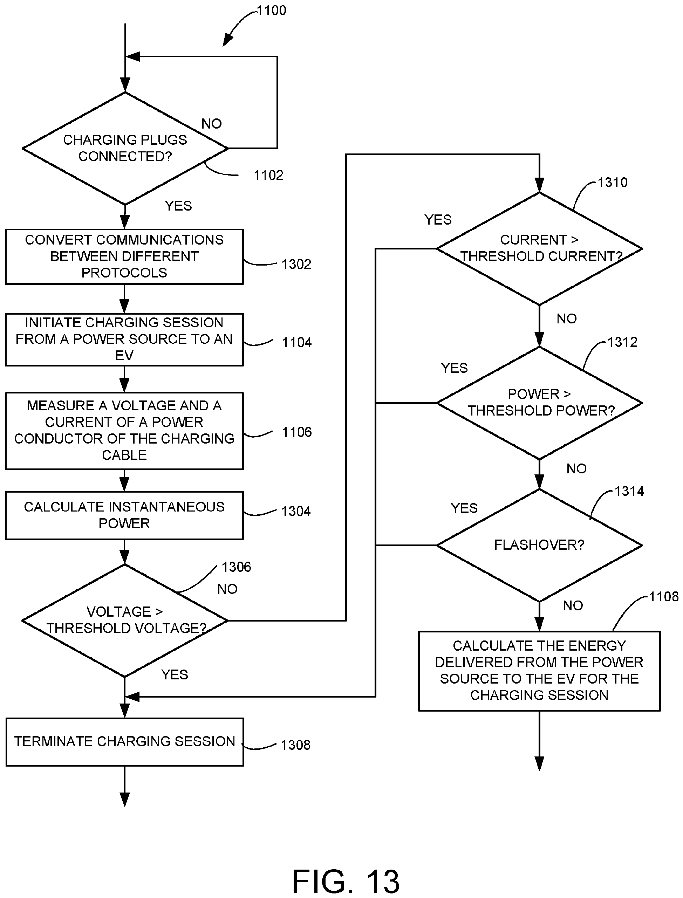

FIG. 11 is a flow chart of a method 1100 of operating a cross-connect cable to charge an EV in an exemplary embodiment. FIGS. 12 and 13 depict additional details of method 1100 in various exemplary embodiments. Method 1100 may be performed by one or more systems shown and described with respect to FIGS. 1-10.

Method 1100 begins by determining (1102) whether a first charging plug and a second charging plug of the cross-connect cable have been electrically connected to a first charging port of a power source and a second charging port of the EV, respectively. For example, controllers 122, 1000 may sense the voltages at charging plugs 114, 116 and/or may detect communications at charging plugs 114, 116, to determine if charging plugs 114, 116 are electrically connected. In another example, a user may indicate the connection via an application executing on LTE 140 or via a button on cross-connect cable 102, not shown.

Method 1100 continues by initiating (1104) a charging session from the power source to the EV in response to determining that the first charging plug and the second charging plug have been electrically connected. For example, charger 104 provides electrical power to charging port 110, which is transferred over wires 108 of cross-connect cable 102 and delivered to charging port 112 of EV 106.

Method 1100 continues by measuring (1106) a voltage and a current of one or more power conductors of the cross-connector cable. For example, processor 124 (see FIG. 1) measures the voltages at charging plug 114 and/or charging plug 116 utilizing sensors 136 and ADC 130. Processor 1004 (see FIG. 10) also measures the current flowing through power conductors 1036, 1038 using current sensors 1034 and ADC 1030. Each of power conductors 1036, 1038 in FIG. 10 may utilize its own current sensor 1034.

Method 1100 continues by calculating (1108) the energy delivered from the power source to the EV for the charging session based on the voltage and current measurements. For example, processor 124 (see FIG. 1) calculates the energy delivered by charger 104 to EV 106 via cross-connect cable 102.

In an optional embodiment, method 1100 further comprises receiving (see 1202 of FIG. 12) at least one of a key, a certificate, and a password for authentication charging sessions. For example, processor 124 (see FIG. 1) utilizes wireless interfaces 134 to receive the key, the certificate, and/or the password via network 138, which are stored in TPM 128. In another example, processor 1004 (see FIG. 10) utilizes modem 1010 to receive the key, the certificate, and/or the password via a cellular network, which are stored in EEPROM 1006).

Method 1100 continues in this optional embodiment in FIG. 12 by determining (1102) whether a first charging plug and a second charging plug of the cross-connect cable have been electrically connected to a first charging port of a power source and a second charging port of the EV, respectively, as previously described with respect to FIG. 11.

In response to the charging plugs being connected, method 1100 continues in this optional embodiment by transmitting (1204) the at least one of the key, the certificate, and the password to the power source. For example, processor 124 utilizes wireless interfaces 134 to transmit secure information stored at TPM 128 to charger 104 (see FIG. 1). Charger 104 may then provide the key, the certificate, and/or the password to the cloud via network 138. The cloud checks the key, the certificate, and/or the password with its authorization registry database to determine if the charging session should be authenticated (1206). If he cloud does not authenticate cross-connect cable 102, then no charging occurs (1208).

If the cloud authenticates cross-connect cable 102 identification using the key, the certificate, and/or the password, then the cloud sends a command to charger 104 to initiate (1104) the charging session, and method 1100 continues in FIG. 12 by measuring (1106) the voltage and current of the power conductors and calculating (1108) the energy delivered from the power source to the EV as previously described with respect to FIG. 11.

In another optional embodiment, method 1100, in response to determining (see 1102 of FIG. 13) that the charging plugs are connected, further comprises converting (1302) communications carried by one or more communication lines of cross-connect cable between a first protocol and a second protocol during the charging session. For example, processor 124 converts CCS2 communications at charging plug 114 to CHAdeMO at charging plug 116, as depicted in FIG. 5.

In this optional embodiment, method 1100 continues as previously described by initiating (1104) a charging session and measuring (1106) a voltage and current at the power conductors. In this optional embodiment, method 1100 calculates (1304) an instantaneous power based on the voltage(s) and current(s) in the power conductors. For example, processor 1004 (see FIG. 10) calculates the instantaneous power utilizing voltage sensor 1032 and current sensor 1034.

Method 1100 continues in this optional embodiment by determining (1306) if the voltage is greater than a threshold voltage. If the voltage is greater than the threshold voltage, then method 1100 terminates (1308) the charging session. For example, processor 124 (see FIG. 1) opens switch 142 utilizing I/O control module 132. In another example, processor 1004 (see FIG. 10) opens switches 1048, 1050 utilizing I/O module 1046

However, if the voltage is not greater than the threshold voltage, then method 1100 continues by determining (1310) if the current is greater than a threshold current, determining (1312) if the instantaneous power is greater than a threshold power, and determining (1314) if a flashover has occurred. For example, processor 124 (see FIG. 1) may utilize sensors 136 to perform the checks. In another example, processor 1004 (see FIG. 10) may utilize voltage sensor 1032, current sensor 1034, arc flash sensor 1020 and/or IR sensor 1022 to perform the checks.

If any of the prior checks are true, then method 1100 terminates (1308) the charging session (e.g., by opening switches 142, 1048, 1050). However, if none of these checks are true, then method 1100 continues by calculating (1108) the energy delivered from the power source to the EV for the charging session as previously described for FIG. 11.

In some embodiments, initiating the charging session further comprises closing at least one switch controlling an electrical path through the one or more power conductors between the first charging plug and the second charging plug. For example, processor 124 directs I/O control module 132, to initiate the charging session, to close switch 142. Closing switch 142 provides an electrical path through wiring 108 between charging plugs 114, 116. Conversely, opening the switch terminates the charging session. For instance, processor 124 directs I/O control module 132 to open switch 142, which terminates the charging session. In another example, processor 1004 directs I/O module 1046, to initiate the charging session, to close switches 1048, 1050. Closing switches 1048, 1050 provide an electrical path through wiring 108. Conversely, opening the switch terminates the charging session. For instance, processor 1004 directs I/O module 1046 to open switches 1048, 1050, which terminates the charging session

The cross-connect cables 102 described herein provide a number of advantages to the EV user as compared to the typical public charge point, including energy transaction verification, energy transaction history, flexibility regarding where the user can charge the EV by selecting different cross-connect cables 102, simpler authentication using cross-connect cable 102 rather than the vendor-specific authentication methods and application which vary depending on the vendor of the charge point, etc. Further, the cross-connect cables 102 described herein provide bi-directional charging, thereby enabling emergency charging between EVs in cases where an EV no longer has the range to reach a charge point. Each of these, at least, provides technical effects and advantages over the art.

Although specific features of various embodiments of the disclosure may be shown in some drawings and not in others, this is for convenience only. In accordance with the principles of the disclosure, any feature of a drawing may be referenced and/or claimed in combination with any feature of any other drawing.

This written description uses examples to disclose the embodiments, including the best mode, and also to enable any person skilled in the art to practice the embodiments, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

**Claims**

1. A cross-connect cable (102) for charging an electric vehicle (EV) (106), the cross-connect cable comprising:

   wiring (108) comprising one or more power conductors (1036, 1038) and one or more communication lines (1044);
   a first charging plug (114) electrically coupled with the wiring;
   a second charging plug (116) electrically coupled with the wiring, wherein the first charging plug and the second charging plug are disposed at opposite ends of the wiring;
   at least one sensor (136, 1020, 1022, 1032, 1034) configured to:

      measure a voltage of the one or more power conductors; and
      measure a current carried by the one or more power conductors; and

   a controller (122, 1000) communicatively coupled with the wiring and the at least one sensor, the controller is configured to:

      determine whether the first charging plug and the second charging plug have been electrically connected to a first charging port (110) of a power source (104) and a second charging port (112) of the EV, respectively;
      initiate a charging session from the power source to the EV in response to determining that the first charging plug and the second charging plug have been electrically connected; and
      calculate, based the voltage and the current, energy delivered from the power source to the EV for the charging session.

2. The cross-connect cable of claim 1, further comprising:

   at least one wireless interface (134),
   wherein the controller is further configured to:

      receive, utilizing the at least one wireless interface, at least one of a key, a certificate, and a password to authenticate the charging session;
transmit, utilizing the at least one wireless interface, the at least one of the key, the certificate, and the password to the power source; and
initiate the charging session from the power source to the EV in response to the at least one of the key, the certificate, and the password authenticating the charging session.

3. The cross-connect cable of claim 2, wherein:
the at least one wireless interface comprises one or more of an ANT interface, an ANT+ interface, a Wi-Fi interface, a Bluetooth interface, and a radio frequency identification (RFID) interface.

4. The cross-connect cable of any one of the preceding claims, wherein:

the first charging plug comprises a first type of charging interface that specifies a first communication protocol,
the second charging plug comprises a second type of charging interface that specifies a second communication protocol, and
the controller is further configured to:
convert communications carried by the one or more communication lines between the first communication protocol and the second communication protocol during the charging session.

5. The cross-connect cable of any one of the preceding claims, further comprising:

at least one switch (142, 1048, 1050) in an electrical path with the one or more power conductors between the first charging plug and the second charging plug,
wherein the controller is further configured to:

close the switch to initiate the charging session; and
open the switch to terminate the charging session.

6. The cross-connect cable of claim 5, wherein:

the at least one sensor is further configured to detect a flashover at one or more of the first charging plug and the second charging plug, and
the controller is further configured to:

determine, utilizing the at least one sensor, whether the flashover has occurred; and
open the switch to terminate the charging session in response to determining that the flashover has occurred.

7. The cross-connect cable of claim 5 or 6, wherein:
the controller is further configured to:

determine whether the voltage is greater than a threshold voltage;
determine whether the current is greater than a threshold current; and
open the switch to terminate the charging session in response to determining that either the voltage is greater than the threshold voltage or the current is greater than the threshold current.

8. The cross-connect cable of any one of the claims 5 to 7, wherein:
the controller is further configured to:

calculate, based the voltage and the current, instantaneous power provided by the power source to the EV during the charging session;
determine whether the instantaneous power is greater than a threshold power; and
open the switch to terminate the charging session in response to determining that the instantaneous power is greater than the threshold power.

9. A method (1100) of operating a cross-connect cable (102) to charge an electric vehicle (EV) (106), the method comprising:

determining (1102), by a controller (122, 1000) of the cross-connect cable, whether a first charging plug (114) and a second charging plug (116) of the cross-connect cable have been electrically connected to a first charging port (110) of a power source (104) and a second charging port (112) of the EV, respectively, wherein the first charging plug and the second charging plug are disposed at, and are electrically coupled to, opposite ends of wiring (108) of the cross-connect cable, and wherein the wiring comprises one or more power conductors (1036, 1038) and one or more communication lines (1044);

initiating (1104) a charging session from the power source to the EV in response to determining that the first charging plug and the second charging plug have been electrically connected;

measuring (1106), by at least one sensor (136, 1020, 1022, 1032, 1034) of the cross-connect cable, a voltage of the one or more power conductors;

measuring (1106), by the at least one sensor, a current carried by the one or more power conductors; and

calculating (1108), by the controller, energy delivered from the power source to the EV for the charging session based the voltage and the current.

10. The method of claim 9, further comprising:

receiving (1202), utilizing at least one wireless interface (134), at least one of a key, a certificate, and a password to authenticate the charging session;

transmitting (1204), utilizing the at least one wireless interface, the at least one of the key, the certificate, and the password to the power source; and

initiating (1104) the charging session from the power source to the EV in response to the at least one of the key, the certificate, and the password authenticating the charging session.

11. The method of claim 9 or 10, wherein:

the first charging plug comprises a first type of charging interface that specifies a first communication protocol, the second charging plug comprises a second type of charging interface that specifies a second communication protocol, and

the method further comprises:

converting (1302), by the controller, communications carried by the one or more communication lines between the first communication protocol and the second communication protocol during the charging session.

12. The method of any one of the claims 9 to 11, wherein initiating the charging session further comprises:

closing at least one switch (142, 1048, 1050) controlling an electrical path through the one or more power conductors between the first charging plug and the second charging plug.

13. The method of claim 12, further comprising:

determining (1314), utilizing the at least one sensor of the cross-connect cable, whether a flashover has occurred at one or more of the first charging plug and the second charging plug; and

opening (1308) the switch to terminate the charging session in response to determining that the flashover has occurred.

14. The method of claim 12 or 13, further comprising:

determining (1306) whether the voltage is greater than a threshold voltage;

determining (1310) whether the current is greater than a threshold current; and

opening (1308) the switch to terminate the charging session in response to determining that either the voltage is greater than the threshold voltage or the current is greater than the threshold current.

15. The method of any one of the claims 12 to 14, further comprising:

calculating (1304), based the voltage and the current, instantaneous power provided by the power source to the EV during the charging session;

determining (1312) whether the instantaneous power is greater than a threshold power; and

opening (1308) the switch to terminate the charging session in response to determining that the instantaneous power is greater than the threshold power.

Cross-Connect Cable 102

Controller 122

Memory 126

Processor 124

I/O Control Module 132

TPM 128

ADC 130

Switch 142

Wireless Interfaces 134

Sensor 136

Charger 104

Network 138

106

112

116

120

108

118

114

110

140

FIG. 1

**FIG. 2**

J1772 to Mennekes

**FIG. 3**

Mennekes to J1772

FIG. 4

FIG. 5

CHAdeMO to CCS2

**FIG. 6**

CHAdeMO to CHAdeMO

**FIG. 7**

EP 4 311 711 A1

FIG. 8

FIG. 9

FIG. 10

1100

CHARGING PLUGS
CONNECTED?

NO

1102

YES

INITIATE CHARGING SESSION
FROM A POWER SOURCE TO AN
EV

1104

MEASURE A VOLTAGE AND A
CURRENT OF A POWER
CONDUCTOR OF THE CHARGING
CABLE

1106

CALCULATE THE ENERGY
DELIVERED FROM THE POWER
SOURCE TO THE EV FOR THE
CHARGING SESSION

1108

# FIG. 11

1100

RECEIVE A KEY, A CERTIFICATE, AND/OR A PASSWORD TO AUTHENTICATE THE CHARGING SESSION — 1202

CHARGING PLUGS CONNECTED? — 1102

NO

YES

TRANSMIT THE KEY, THE CERTIFICATE, AND/OR THE PASSWORD TO THE POWER SOURCE — 1204

CHARGING SESSION AUTHENTICATED? — 1206

NO

1208

NO CHARGING

YES

INITIATE CHARGING SESSION FROM A POWER SOURCE TO AN EV — 1104

MEASURE A VOLTAGE AND A CURRENT OF A POWER CONDUCTOR OF THE CHARGING CABLE — 1106

CALCULATE THE ENERGY DELIVERED FROM THE POWER SOURCE TO THE EV FOR THE CHARGING SESSION — 1108

# FIG. 12

FIG. 13

Europäisches
Patentamt

European
Patent Office

Office européen
des brevets

# EUROPEAN SEARCH REPORT

Application Number

EP 23 18 7089

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/144728 A1 (HARPER JASON [US] ET AL) 26 May 2016 (2016-05-26) | 1,3,5,9, 12 | INV. B60L3/00 |
| Y | * paragraphs [0035], [0039], [0045], [0047], [0048], [0051], [0052], [0059] – [0069], [0081], [0087]; figures 1-5 * | 2,4,6-8, 10,11, 13-15 | B60L53/16 B60L53/18 B60L53/30 B60L53/66 |
| Y | DE 10 2015 208786 A1 (BAYERISCHE MOTOREN WERKE AG [DE]) 17 November 2016 (2016-11-17) * paragraphs [0003], [0004], [0007], [0015], [0016], [0032], [0029], [0037] – [0040], [0044], [0050] * | 2,4,10, 11 | ADD. B60L3/12 |
| Y | EP 3 992 018 A1 (BURY SP ZOO [PL]) 4 May 2022 (2022-05-04) | 7,8,14, 15 | |
| A | * paragraphs [0046], [0047] * | 5 | |
| Y | Anonymous: "13A EV Charger Connectors , IC-CPD EV Charging Plug With Indicator LED Lights", , 29 November 2021 (2021-11-29), pages 1-3, XP093112487, Retrieved from the Internet: URL:https://web.archive.org/web/2021112900 2251/https://www.batteriesconnector.com/sa le-13960199-13a-ev-charger-connectors-ic-c pd-ev-charging-plug-with-indicator-led-lig hts.html [retrieved on 2023-12-15] | 7,8,14, 15 | |
| A | * the whole document * | 5 | |
| Y | US 2011/258112 A1 (EDER JOHN [US] ET AL) 20 October 2011 (2011-10-20) * paragraph [0038] * | 6,13 | |

TECHNICAL FIELDS SEARCHED (IPC)

B60L

The present search report has been drawn up for all claims

| Place of search | Date of completion of the search | Examiner |
|---|---|---|
| The Hague | 18 December 2023 | Schury, Dominik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## EP 4 311 711 A1

This annex lists the patent family members relating to the patent documents cited in  the above-mentioned European search report.
The members are as contained in the European Patent Office EDP file on
The European Patent Office is in no way liable for these particulars which are merely given for the purpose of information.

18-12-2023

| Patent document cited in search report | Publication date | Patent family member(s) | Publication date |
|---|---|---|---|
| US 2016144728    A1 | 26-05-2016 | EP      3221917 A1<br>US   2016144728 A1<br>WO   2016081498 A1 | 27-09-2017<br>26-05-2016<br>26-05-2016 |
| DE 102015208786 A1 | 17-11-2016 | CN      107580566 A<br>DE 102015208786 A1<br>EP      3294587 A1<br>US   2018091191 A1<br>WO   2016184711 A1 | 12-01-2018<br>17-11-2016<br>21-03-2018<br>29-03-2018<br>24-11-2016 |
| EP 3992018       A1 | 04-05-2022 | DE 102020128736 A1<br>EP      3992018 A1 | 05-05-2022<br>04-05-2022 |
| US 2011258112    A1 | 20-10-2011 | CA      2733288 A1<br>US   2011258112 A1<br>WO   2010051477 A2 | 06-05-2010<br>20-10-2011<br>06-05-2010 |

EPO FORM P0459

For more details about this annex : see Official Journal of the European Patent Office, No. 12/82